# DEMANDE DE BREVET EUROPEEN

(11) **EP 3 115 128 A1**
(43) Date de publication de la demande: **11.01.2017**
(21) Numéro de dépôt: 16178287.5
(22) Date de dépôt: 07.07.2016
(51) Int. Cl.: B22F 1/00, B22F 7/06, H01L 23/00

(54) **ASSEMBLAGE COMPRENANT DEUX ELEMENTS DE COEFFICIENT DE DILATATION THERMIQUE DIFFERENTS ET UN JOINT FRITTE HETEROGENE EN DENSITE ET PROCEDE DE FABRICATION DE L'ASSEMBLAGE**

(30) Priorité: 10.07.2015 FR 1556573
(71) Demandeur: COMMISSARIAT A L'ENERGIE ATOMIQUE ET AUX ENERGIES ALTERNATIVES, 75015 Paris (FR)
(72) Inventeur: KHAZAKA, Rabih, 38700 La Tronche (FR); THOLLIN, Benoît, 38330 Montbonnot St Martin (FR)
(74) Mandataire: Esselin, Sophie

(57) **Abrégé**

L'invention a pour objet un assemblage comprenant un premier élément présentant un premier coefficient de dilatation thermique, un second élément présentant un second coefficient de dilatation thermique et au moins un joint reliant ledit premier élément et ledit second élément, caractérisé en ce que ledit joint est hétérogène et comporte un empilement d'au moins un premier joint élémentaire de première densité et d'un second joint élémentaire de seconde densité, lesdites première et seconde densités étant différentes.

L'invention a aussi pour objet un procédé de fabrication d'un assemblage selon l'invention.

## Description

Le domaine de l'invention est celui des techniques d'assemblage de deux éléments via des joints frittés et notamment celui de l'assemblage de composants sur des substrats permettant par exemple de reporter une puce semi-conductrice sur un substrat métallisé avec ou sans métaux nobles, destinés avantageusement à des applications forte densité de puissance et haute température (supérieure à 200 °C).

De manière connue, pour former des composants électroniques, des éléments semi-conducteurs doivent être attachés sur des substrats. Les brasures à base de plomb (Pb-Sn, Pb-Sn-Ag) et d'étain (Sn-Ag, Sn-Ag-Cu) sont parmi les plus utilisées dans le domaine de l'électronique. Cependant, les régulations européennes interdisent l'utilisation du Pb à cause de sa toxicité environnementale. Les brasures à base d'étain (Sn) sont limitées à des températures faibles (inférieure à 200 °C) et ne correspondent pas aux températures visées par les semi-conducteurs grand gap comme le carbure de silicium SiC ou le nitrure de gallium GaN.

D'autres brasures hautes températures existent. Elles sont soit à base d'or (Au) les rendant très chères, soit présentent une température de fusion très élevée (supérieure à 500 °C) non compatible avec les semi-conducteurs.

Les brasures à base d'Au comme les alliages AuSn, AuGe, AuSi présentent des modules de Young élevés par rapport aux brasures à base de Pb ce qui induit des contraintes très élevées sur les composants assemblés menant dans certains cas à la casse des composants.

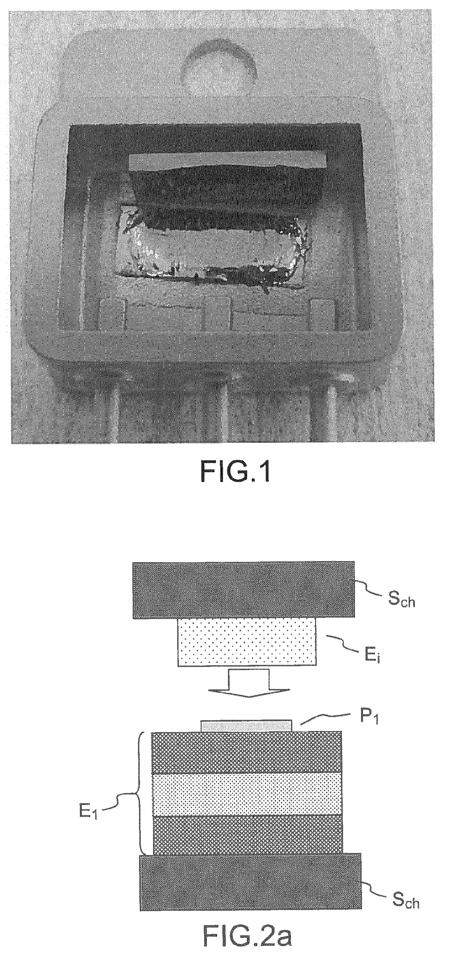

Un exemple de ce problème est illustré sur la figure 1 montrant la fracture dans un composant GaN sur Si (1 mm de Si) suite à un brasage AuSn à 300 °C dans un boitier avec une semelle en Cu (finition Ni/Au).

De plus, les brasures présentent des conductivités thermiques relativement faibles (de l'ordre de 40W/mK) en plus des problèmes de fiabilité lors de stockage à haute température (création d'intermétalliques fragiles et vides de Kirkendall : la diffusion de matière dans un sens entraîne la diffusion de vide (lacune) dans l'autre, pouvant provoquer une déformation de la matière) et lors des cyclages thermiques (propagation des fissures dans le joint).

Pour éviter l'utilisation des brasures, d'autres technologies telles que le frittage de micro et nanoparticules métalliques et l'attache par « TLP » (transient liquid phase) correspondant à un soudage par diffusion en phase sont en pleine expansion.

Le frittage de microparticules métalliques a fait l'objet de différentes études comme celle de Zhang et al., «Pressure-Assisted Low-Temperature Sintering of Silver Paste as an Alternative Die-Attach Solution to Solder reflow », IEEE Transactions on Electronics Packaging Manufacturing, vol. 25, no. 4, October, 2002 (pp 279-283). Il y est proposé une pâte contenant des particules d'Ag de plusieurs µm de diamètre, nécessitant des températures très élevées pour le frittage (600 °C). Afin de pouvoir réduire cette température vers des valeurs plus compatibles avec les composants électroniques, des pressions de plusieurs dizaines de MPa sont nécessaires rendant le procédé d'assemblage très compliqué (surtout pour l'assemblage de plusieurs composants ayant des épaisseurs différentes) et non compatible avec les composants sensibles aux fortes pressions.

Une réduction de la température et de la pression lors du frittage est possible en utilisant des particules métalliques de tailles nanométriques. Il est préférable que la pâte contienne un dispersant pour éviter l'agglomération des nanoparticules. Un liant polymère est aussi ajouté au dispersant et aux nanoparticules pour assurer l'aspect de la pâte (soit une solution pâteuse) et limiter l'apparition des fissures lors du séchage. Le solvant permet d'obtenir des viscosités variables et adaptées à différentes techniques de dépôt (« dispensing » : dépôt à l'aide d'un stylet de dosage , et « screen-printing ») : sérigraphie). Le développement de ce type de pâtes contenant des particules nanométriques a fait l'objet d'un brevet par Lu *et al., « Nanoscale metal paste for interconnect and methode of use »,* US 8,257,795 B2. Ce type de pâte, ne nécessitant aucune pression lors du frittage, est compatible avec des couches de finition en Ag ou en Au (matériaux nobles qui permettent d'améliorer l'adhésion de l'interconnexion).

Le procédé de frittage des pâtes de nanoparticules métalliques joue un rôle important sur la densité du joint et par voie de conséquences sur ses propriétés physiques. La relation procédé-densité-propriétés mécaniques a notamment fait l'objet de plusieurs recherches comme celle de Knoerr et al. « Power semiconductor joining through sintering of silver nanoparticles : Evaluation of influence of parameters time, temperature and pressure on density-strength and reliability », International Conference on Integrated Power Electronics Systems CIPS, March 16-18. 2010, Nuremberg, Germany, et celle de Caccuri et al. « Mechanical Properties of Sintered Ag as a New Material for Die Bonding: Influence of the Density», Journal of Electronic Materials, Vol. 43, No. 12, 2014.

Dans ce contexte le Demandeur a cherché à exploiter la latitude offerte en termes de densité par les procédés de frittage pour proposer une solution d'assemblage permettant de former un seul joint hétérogène cumulant différentes propriétés de densité, induisant des propriétés physiques différentes et contrôlées et permettant un meilleur encaissement des contraintes thermomécaniques entre deux éléments présentant des coefficients de dilatation thermique différents, par exemple un dispositif semi-conducteur et un substrat, lors des cycles thermiques. Grâce à la solution proposée dans la présente invention, il est également possible d'améliorer l'adhésion d'un composant sensible à la pression sur un substrat nécessitant de la forte pression en faisant des multi-étapes de frittage.

Plus précisément, la présente invention a pour objet un assemblage comprenant un premier élément présentant un premier coefficient de dilatation thermique, un second élément présentant un second coefficient de dilatation thermique et au moins un joint reliant ledit premier élément et ledit second élément, caractérisé en ce que ledit joint est hétérogène et comporte un empilement d'au moins un premier joint élémentaire de première densité et d'un second joint élémentaire de seconde densité, lesdites première et seconde densités étant différentes.

Le joint hétérogène présente ainsi un premier joint élémentaire de première densité comportant une interface avec le second joint élémentaire de seconde densité.

Selon des variantes de l'invention, l'un des éléments comprend un composant semi-conducteur, pouvant être par exemple une diode silicium.

Selon des variantes de l'invention, ledit joint hétérogène est métallique.

Selon des variantes de l'invention, le premier élément et/ou le second élément présente(nt) une surface métallique et reliée audit joint.

Selon des variantes de l'invention, un des deux éléments est un substrat pouvant être de type « DBC » pour « Direct Bonded Copper », correspondant à une plaque pouvant être du Al₂O₃ ou du Si₃N₄ ou du AIN, et comportant au moins une couche métallique sur l'une de ses faces. Il peut d'agir d'un film de cuivre collé directement sur une plaque de céramique.

Ce type de substrat est particulièrement performant dans le cadre de composants de puissance, devant tenir les hautes températures.

Selon des variantes de l'invention, le premier élément et le second élément présentent une couche de finition destinée à être en contact avec un des joints élémentaires.

Selon des variantes de l'invention, l'épaisseur de la couche de finition est de l'ordre du nanomètre ou du micron (pouvant ainsi varier entre quelques nanomètres et jusqu'au micron voir plus).

Selon des variantes de l'invention le premier joint élémentaire et le second joint élémentaire comportent des nanoparticules.

Selon des variantes de l'invention, le premier joint élémentaire comporte des microparticules ou des nanoparticules, le second joint élémentaire comportant des nanoparticules (ceci peut être particulièrement intéressant dans le cas de composants semiconducteurs sensibles à la pression).

Selon des variantes de l'invention, au moins un des premier et/ou second éléments comporte(nt) une surface en cuivre, pouvant être une couche de finition.

Selon des variantes de l'invention, le premier joint élémentaire est à base d'argent, le second joint élémentaire étant également à base d'argent.

Selon des variantes de l'invention, le premier joint élémentaire est à base de cuivre, le second joint élémentaire étant également à base de cuivre.

Selon des variantes de l'invention, le premier joint élémentaire est à base d'or le second joint élémentaire étant également à base d'or.

Selon des variantes de l'invention, le premier joint élémentaire est à base d'argent et de cuivre, le second joint élémentaire étant également à base d'argent et de cuivre.

Selon des variantes de l'invention, la première densité est de l'ordre de 90% par rapport au métal massif pouvant être de l'argent, la seconde densité étant de l'ordre de 60 % par rapport au métal massif pouvant être de l'argent.

L'invention a aussi pour objet un procédé de fabrication d'un assemblage comprenant un joint hétérogène et deux éléments de coefficient de dilatation thermique différents, comprenant les étapes suivantes :
- le dépôt d'une première pâte ou d'un premier film à la surface du premier élément ;
- une première opération de frittage dans des premières conditions de température et de pression de manière à réaliser un premier joint élémentaire de première densité ;
- le dépôt d'une seconde pâte ou d'un second film à la surface dudit premier joint élémentaire ;
- une seconde opération de frittage dans des secondes conditions de température et de pression de manière à définir un second joint élémentaire de seconde densité différente de ladite première densité à la surface du premier joint élémentaire pour former ledit joint hétérogène ;
- l'application du second élément.

Selon des variantes de l'invention, la seconde opération de frittage est réalisée dans des conditions de température et/ou de pression moins élevée(s) que celles de la première opération de frittage.

Selon des variantes de l'invention, la première opération de frittage est réalisée en appliquant une pièce intermédiaire sur ladite première pâte déposée ou sur ledit premier film, qui n'adhère pas sur ladite première pâte ou sur ledit premier film. Cette pièce intermédiaire peut être une plaque de verre ou un élément en polytétrafluoroéthylène (PTFE) couramment dénommé Téflon® ou un élément en céramique, ou un élément en aluminium, ou un élément en diamant, ou un élément en saphir, ou un élément en silicium, ou un élément en carbure de silicium.

Selon des variantes de l'invention, la seconde opération de frittage est réalisée en appliquant le second élément sur la seconde pâte ou sur le second film.

Selon des variantes de l'invention, le procédé comprend une étape de séchage de ladite première pâte et/ou une étape de séchage de ladite seconde pâte. Cette étape peut permettre d'obtenir des épaisseurs de joints mieux contrôlées pour le frittage sous pression (les conditions et temps dépendant de la température d'évaporation du liant et du solvant se trouvant dans la pâte).

Selon des variantes de l'invention, la première et/ou la seconde pâte est(sont) métallique(s) ou le premier film et/ou le second film est(sont) métallique(s).

Selon des variantes de l'invention, la première et la seconde pâte sont métalliques.

Selon des variantes de l'invention, le dépôt de la première pâte et/ou le dépôt de la seconde pâte est(sont) réalisé(s) par sérigraphie.

Selon des variantes de l'invention, le dépôt de la première pâte et le dépôt de la seconde pâte sont réalisés par sérigraphie avec le même type de pâte à fritter, l'épaisseur de la première pâte déposée pouvant être plus élevée que l'épaisseur de la seconde pâte déposée. Le même type de pâte peut être une pâte à fritter nécessitant l'application d'une pression, le second dépôt pouvant être réalisé pour obtenir une épaisseur suffisamment faible, pouvant typiquement être inférieure à quelques dizaines de microns (30 microns par exemple) pour s'affranchir d'une étape de séchage alors que généralement une telle étape est nécessaire en raison des liants devant être évacués avec ce type de pâte à fritter lors de la réalisation de l'assemblage. Typiquement, il peut s'agir de pâte à base de microparticules d'argent (les pâtes à fritter dites sans pression pouvant être à base de nanoparticules d'argent.

Selon des variantes de l'invention, le dépôt de la première pâte et/ou le dépôt de la seconde pâte est(sont) réalisé(s) par dépôt à l'aide d'un stylet de dosage (« dispensing »).

Selon des variantes de l'invention, le dépôt de la première pâte et/ou le dépôt de la seconde pâte est(sont) réalisé(s) par impression directe (« imprint »).

Selon des variantes de l'invention, le premier élément comprenant une surface en cuivre, la première pâte est à base d'argent, la seconde pâte étant également à base d'argent.

Selon des variantes de l'invention, la première et la seconde pâte comprend(comprennent) des nanoparticules et peut (peuvent) comprendre un dispersant et/ou un liant et/ou un solvant.

Selon des variantes de procédé de fabrication d'un assemblage comprenant un joint hétérogène selon l'invention, la première et/ou la seconde pâte comprend(comprennent) des nanoparticules métalliques.

Selon des variantes de procédé de fabrication d'un assemblage comprenant un joint hétérogène selon l'invention, le premier élément est un substrat, le second élément est une puce semiconductrice.

Le joint hétérogène en densité proposé dans la présente demande de brevet peut permettre également d'assurer une bonne adhésion sur les métaux « non-noble » (Cu ou Ni) ou autre substrats nécessitant généralement la présence d'une forte pression pour assurer une bonne adhésion (meilleure adhésion due à la déformation plastique du substrat et le mécanisme d'accrochage (couramment dénommé « interlocking ») par exemple avec une rigidité en cisaillement supérieure à 10 MPa sans avoir besoin d'appliquer une pression sur les puces lors de montage, comme il sera explicité ci-après dans la description détaillée de la présente demande de brevet.

L'invention sera mieux comprise et d'autres avantages apparaîtront à la lecture de la description qui va suivre donnée à titre non limitatif et grâce aux figures annexées parmi lesquelles :
- la figure 1 illustre la fracture dans un composant GaN sur Si (1 mm de Si) suite à un brasage AuSn à 300 °C dans un boitier avec une semelle en Cu (finition Ni/Au) ;
- les figures 2a à 2c illustrent les principales étapes d'un procédé de réalisation d'un assemblage selon l'invention ;
- les figures 3a à 3c illustrent des exemples de porosités obtenues selon différentes opérations de frittage pour obtenir des joints élémentaires dans un assemblage de l'invention ;
- la figure 4 illustre une image d'une coupe d'un exemple de joint hétérogène proposé dans un assemblage selon l'invention ;
- la figure 5 illustre la variation de la rigidité en cisaillement d'une diode Si (finition Al/Ti/Ni/Ag) attachée sur un DBC ayant différentes finitions avec différentes conditions de frittage dans le cadre d'exemples d'assemblage selon l'invention ;
- la figure 6 présente un exemple de la délamination de la couche Ag du Ni (utilisée généralement comme métallisation face arrière des composants) d'une puce Si attachée sur un DBC finition Cu.

La présente invention est particulièrement intéressante dans le cadre d'applications forte densité de puissance et haute température (supérieure à 200 °C), permettant de supprimer les étapes de métallisation par des métaux nobles des substrats métallisés type « DBC » pour « direct bonded copper », « AMB » pour « active métal brazing » et autres, d'assurer une bonne adhésion avec les substrats nécessitant une forte pression et d'améliorer la fiabilité thermomécanique du joint.

Le substrat de type « AMB » *(Active Metal Brasing)* comporte un film ou couche intercalé (e) entre le substrat céramique et le film de cuivre. Une augmentation de température jusqu'à celle de la fusion du film « AMB » sans pression généralement de l'ensemble permet de faire réagir par des phénomènes de diffusion le film AMB avec, d'une part le cuivre, et d'autre part le substrat céramique.

Typiquement, la présente invention permet de réaliser des interconnexions électriques et/ou mécaniques pouvant fonctionner à des températures supérieures à 300 °C avec, lors de l'assemblage des composants actifs, un profil de température de procédé inférieur à 250 °C et des pressions très faibles, inférieures typiquement à 100 g/cm² (ou même sans pression) en utilisant des pâtes contenant des nanoparticules métalliques. Elle permet aussi d'obtenir des joints avec une variance des propriétés au sein du même joint et assure une bonne adhésion mécanique sur des substrats ou la pression lors de frittage est nécessaire, sans avoir besoin de venir appuyer sur les composants actifs.

Elle consiste tout d'abord à réaliser une première couche frittée avec une pression élevée sur le substrat (nécessitant une forte pression pour assurer une bonne adhésion mécanique) en utilisant une plaque plane qui n'adhère pas sur le joint fritté (verre, aluminium, téflon, Al₂O₃...). La plaque est ensuite enlevée après cette première partie. Cette même étape peut être reproduite plusieurs fois avec des conditions de frittage différentes pour obtenir des densités du joint différentes (pressions et/ou températures plus faibles pour avoir un joint moins dense). Comme cette étape se fait sans la présence des semi-conducteurs, des pâtes contenant des particules de tailles micrométriques peuvent être utilisées avec des procédés de frittage hautes températures et fortes pressions.

Une pâte avec des particules de tailles nanométriques est déposée ensuite sur le joint déjà fritté. Le semi-conducteur est ensuite placé sur la pâte et une pression modeste (pouvant être inférieure à 100g/cm²) est appliquée pour assurer un bon contact entre la pâte et la métallisation de la puce.

Un cycle de température permettant de fritter la pâte de nano particules est ensuite appliqué. A la fin du procédé, une interconnexion électrique et mécanique est assurée entre le semi-conducteur et le substrat.

La densité de la dernière étape du joint peut aussi être contrôlée par le procédé même sans varier la pression. Cette technique d'interconnexion présente les avantages suivants :
o tous les avantages classiques des joints frittés (une bonne conductivité thermique et électrique, une température de fonctionnement supérieure à la température de procédé ...) ;
o une faible pression ou sans pression pour les composants sensibles permettant d'attacher plusieurs composants avec des épaisseurs différentes, tout en assurant en même temps une bonne adhésion avec les substrats nécessitant de fortes pressions (Cu, Ni, polymères...) ;
o un contrôle de la densité des différentes couches dans un même joint, permettant le contrôle du module élastique et la création des joints avec des couches pouvant encaisser des contraintes thermomécaniques et relaxer le stress aux points critiques (métallisation de la puce par exemple) permettant ainsi une meilleure fiabilité lors des cycles thermiques.

Il est à noter que le procédé de frittage peut être réalisé par conduction à partir de plaques chauffantes. D'autres techniques comme le chauffage par micro-onde ou par laser peuvent être aussi être employées.

### Exemple d'assemblage selon l'invention :

Une diode silicium avec une finition Al/Ti/Ni/Ag est attachée à un DBC sans aucune finition particulière de matériaux nobles (finition Cu) en utilisant plusieurs étapes de frittage.

Notons que, dans le cas d'une couche de finition du substrat en Cu, une étape de désoxydation par de l'acide formique est réalisée juste avant le dépôt de la pâte.

### Premier exemple de procédé de fabrication d'un assemblage selon l'invention :

Le procédé utilisé pour réaliser cet assemblage est illustré en figures 2a à 2c.

### Etape 1 :

Une première couche de pâte d'argent (pâte P1) compatible avec les couches de finition en cuivre est déposée sur le premier élément E1 constitué par le DBC (couche de Al₂O₃ entre deux couches de Cu) par sérigraphie. La pâte d'argent peut typiquement comprendre un dispersant, un liant, un solvant et des nanoparticules d'argent. Une étape de séchage de la pâte est réalisée à 130 °C pendant 30 minutes.

L'opération de frittage est ensuite réalisée en appuyant avec une plaque de verre (la pièce intermédiaire Ei) sur la pâte séchée avec une pression de 12 MPa et une température de 280 °C pendant 200 secondes, comme illustré en figure 2a pour former le premier joint élémentaire J1, la source de chaleur étant référencée S_{ch}. Ces conditions permettent d'avoir une bonne adhésion entre le joint et la couche de Cu avec une rigidité en cisaillement mesurée de 28 MPa (en attachant une puce Si finition Ag). Il est à noter qu'en faisant des essais sous des pressions de 9 MPa et 6 MPa, le Demandeur a constaté des diminutions de la rigidité en cisaillement de 50 % et 80 %.

Sous une pression de 3MPa, la rigidité en cisaillement devient quasiment nulle.

Dans la fabrication de la structure proposée, la plaque de verre Ei se détache facilement du premier joint élémentaire ainsi formé et présentant une première densité.

### Etape 2 :

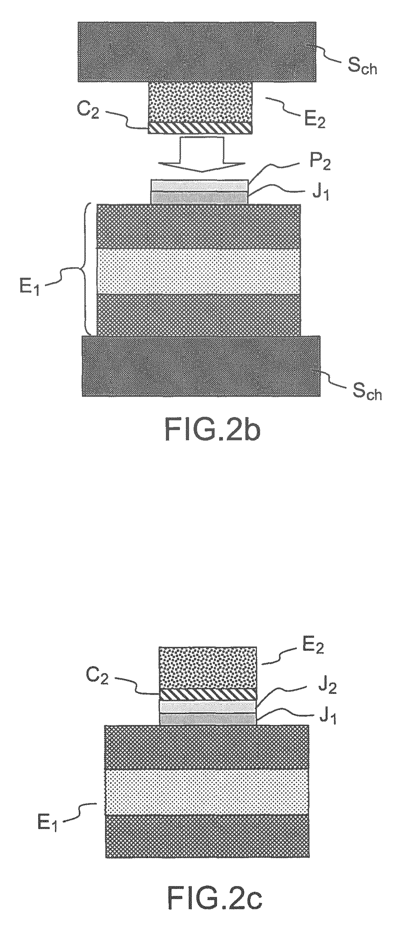

Une seconde couche d'une pâte P2 contenant des nanoparticules d'argent et compatible avec les finitions Ag et Au est déposée par sérigraphie sur le premier joint élémentaire fritté (joint fritté J1), comme illustré en figure 2b.

La puce Si (finition Ag), soit l'élément E2 avec une couche de finition C2, est ensuite posée sur la pâte d'Ag et un cycle de frittage à une température de 250 °C avec une pression très faible (typiquement inférieure à 0,1 MPa) est réalisé (la source de chaleur étant référencée Sch). La pression modeste appliquée assure un bon contact entre la pâte et la puce.

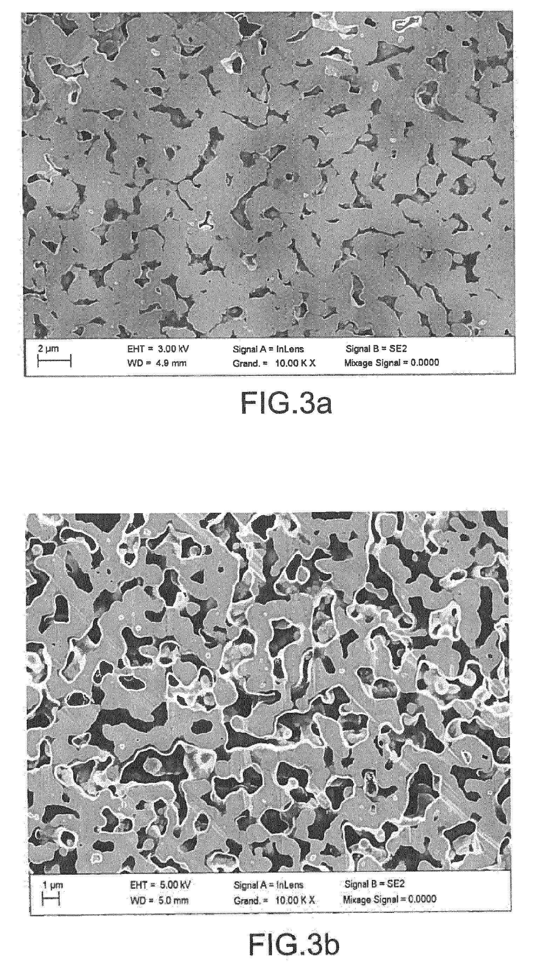

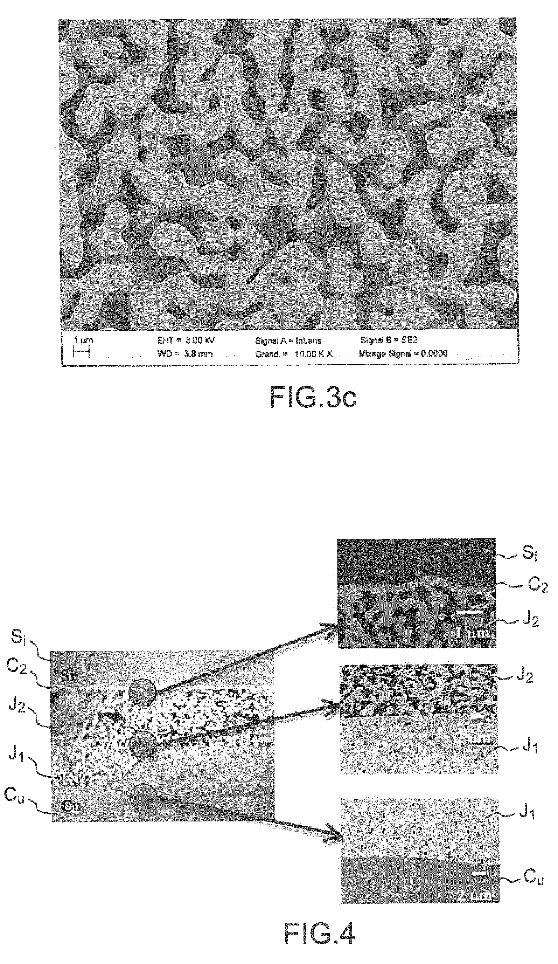

La densité de cette couche peut être contrôlée à travers la rampe de montée en température comme le montrent les images MEB des figures 3a, 3b et 3c prises respectivement à l'issue de rampes de 6, 15 et 30 °C/min.

La diminution de la densité de joint et l'augmentation de la taille et du nombre des pores dans le joint observées en augmentant la rampe de montée en température sont initialement reliées à l'évaporation du solvant, du liant et du dispersant (utilisés pour la formation de la pâte) pendant le frittage. Sous des rampes de montée en température très rapides, les produits volatils n'ont pas le temps de s'échapper du joint avant le début de frittage et leur évaporation au cours du procédé va mener à la création de nombreux et larges pores.

La figure 2c, illustre l'assemblage ainsi réalisé comprenant un joint hétérogène résultant de l'empilement du premier joint élémentaire J1 et du second joint élémentaire J2 permettant d'assembler les éléments E1 et E2.

L'effet de plusieurs paramètres du frittage et différentes couches de finition du DBC sur la rigidité en cisaillement des diodes Si ayant une finition Al/Ti/Ni/Ag a été étudié.

Pour la pâte P2, ne nécessitant pas l'utilisation de pression, il est possible de remarquer que les rigidités moyennes en cisaillement pour une couche de finition en Cu et une couche de finition en Au sont de 4,5 MPa et 13 MPa respectivement en utilisant une température de frittage de 250 °C pendant 20 minutes avec une rampe de montée en température de 30 °C/min. Ces conditions de frittage mènent à une densité de joint comparable à celle présentée sur la figure 3c.

Même en utilisant un procédé permettant d'obtenir un joint bien plus dense (comparable à celui présenté sur figure 3a), la rigidité de cisaillement sur le DBC avec une finition Cu passe à 6,5 MPa. Cette augmentation peut être reliée à la surface de contact plus grande lorsque le joint est plus dense. Après les tests en cisaillement, les observations montrent une délamination coté Cu et côté Au du DBC indiquant une meilleure adhésion avec la métallisation Ag de la puce. Afin de profiter de la bonne adhésion du joint en Ag fritté sur une couche de finition en Ag, la structure présentée dans la figure 4 a été réalisée et testée en cisaillement. Cette figure 4 représente une vue de coupe d'un joint réalisé en deux étapes et montrant les deux couches relatives aux premier joint élémentaire J1 et au second joint élémentaire J2 avec des densités différentes formant le joint final et reliant la couche Cu du DBC et la diode en silicium Si, via la couche C2. Cette structure montre une rigidité moyenne de 19 MPa en utilisant les mêmes conditions de frittage que celles pour avec des couches de finition Au et Cu (250 °C et une rampe de 30 °C/min). Après le test en cisaillement, les observations montrent une délamination coté couche de métallisation Ag de la puce. Un essai de frittage forte pression (12 MPa) de la pâte P1 sur une couche de finition Cu donne la meilleure rigidité en cisaillement avec une valeur moyenne de 28 MPa.

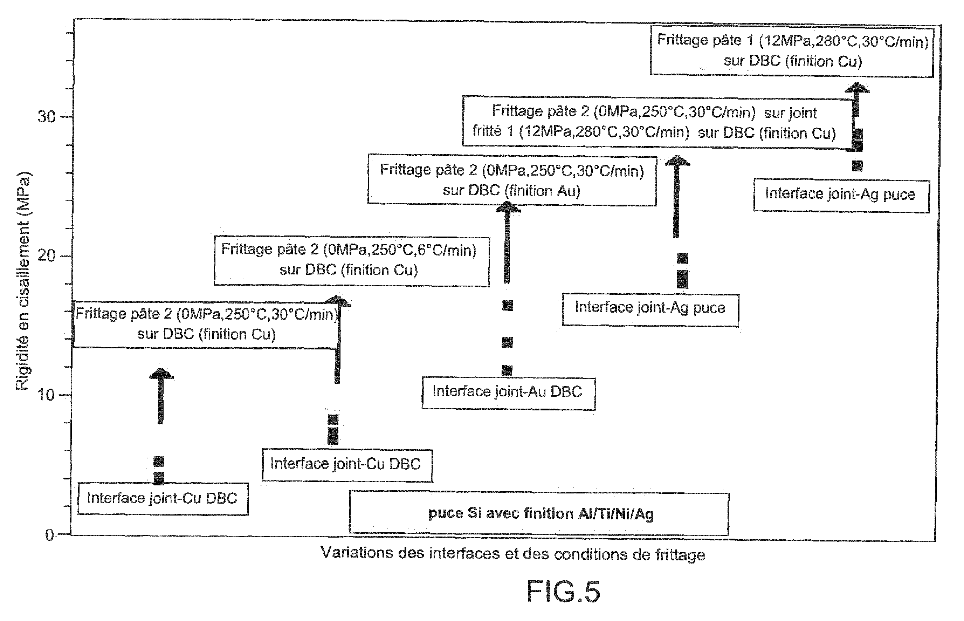

La figure 5 montre la variation de la rigidité mécanique des puces en utilisant plusieurs matériaux de couche de finition et les différentes conditions de frittage déjà mentionnées. De plus, pour chaque condition et suite aux essais de cisaillement, l'interface présentant la plus faible adhésion est indiquée. Pour chaque condition, trois échantillons ont été testés afin d'avoir une statistique acceptable et sont illustrés par trois carrés noirs représentés en figure 5.

Il apparait clairement que la diminution de la densité de joint, induit une diminution de la conductivité thermique et électrique de l'attache de la puce. Par exemple d'après le brevet US 8,257,795 B2, la variation de la densité relative du joint de 80% à 57 % induit une diminution de la conductivité électrique de 4,2x10⁵ à 2,6x10⁵ (Ω.cm)⁻¹ et de la conductivité thermique de 78 à 30 W/mK. Les valeurs les plus faibles restent dans le même ordre de grandeur que les brasures classiques présentées dans le tableau suivant.

| | Au88Ge12 | Pb95.5Sn2Ag2.5 | Au80Sn20 |
|---|---|---|---|
| Conductivité électrique (Ω.cm)⁻¹ | 0.2 x10⁴ | 0.35 x10⁵ | 0.6 x10⁵ |
| Conductivité thermique W/m.K | 44 | 23 | 58 |

Suite à ces résultats, le Demandeur a pu considérer que la diminution de la densité relative de joint jusqu'à 50% reste intéressante pour les propriétés électriques et mécaniques.

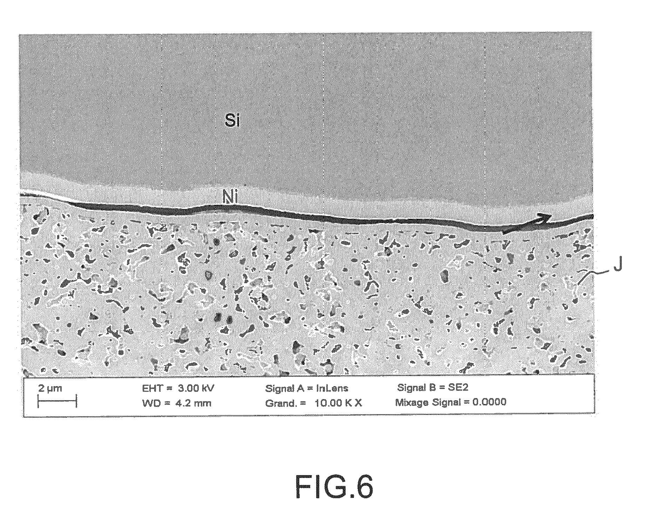

Il est à noter que le procédé d'assemblage avec la pâte 1 avec une pression de 12 MPa permet d'avoir la meilleure rigidité en cisaillement. Cependant, ce procédé n'est pas compatible avec des composants sensibles aux pressions élevées et le joint est très dense (module de Young élevée) ce qui peut engendrer des contraintes élevées sur les métallisations des semi-conducteurs lors des cycles thermiques (différence de CTE entre le Si et le DBC). La figure 6 présente un exemple de la délamination de la couche Ag du Ni (utilisée généralement comme métallisation face arrière des composants) d'une puce Si attachée sur un DBC finition Cu après 700 cycles thermique entre -40 °C et 160 °C en utilisant un joint dense J (joint 1 de la figure 4). Après les 700 cycles, la rigidité en cisaillement passe de 28 MPa à 10 MPa et une délamination de 60 % de la surface initial est observée par SAM (Scanning Acoustique Microscopy). Ce problème de fiabilité thermomécanique peut être retardé ou même évité en utilisant la structure développée de la présente invention permettant d'obtenir un joint de densité relativement faible en contact avec le semi-conducteur. Cela induit un module de Young plus faible et par suite un meilleur encaissement des contraintes thermomécaniques se traduisant par une meilleure fiabilité du joint.

### Second exemple de procédé de fabrication d'un assemblage selon l'invention :

### Etape 1 :

La première étape comprend :
- la sérigraphie de pâte à fritter à l'aide d'un masque de 200µm d'épaisseur sur le substrat ;
- le séchage de la pâte à fritter (30 minutes à 130°C) conduisant à une perte de volume et à une épaisseur de 150 µm ;
- le frittage sous forte pression de la pâte à fritter avec une plaque de verre (12MPa, 275 secondes à 280°C) de manière à former le premier joint élémentaire, conduisant à une épaisseur de 60 µm.

### Etape 2 :

On utilise une pâte à fritter avec pression pour le second dépôt (une telle pâte est généralement moins chère et plus facilement déposable par sérigraphie) tout en appuyant faiblement sur la puce.

Cependant ce type de pâte à fritter avec pression nécessite un séchage pour évacuer les liants organiques, ce qui n'est pas le cas de la pâte à fritter sans pression. Cette étape de séchage, lorsqu'elle est suivie d'un procédé d'assemblage à faible pression a une faiblesse mécanique (la zone de rupture) au niveau de l'interface joint/puce.

La solution proposée dans cette seconde variante est de déposer une très fine couche de ce type de pâte à fritter sur le premier joint élémentaire de manière à se passer de séchage et améliorer de ce fait l'interface joint/puce qui est plus robuste lorsque la pâte est non séchée. On procède aux étapes élémentaires suivantes :
- la sérigraphie de pâte à fritter sur le premier joint élémentaire avec un masque de 70µm d'épaisseur. Lorsque le premier joint élémentaire est fritté, il se densifie, et son épaisseur finale après frittage est de 60µm, ce qui permet un dépôt de 10µm en utilisant un écran de 70µm d'épaisseur ;
- le dépôt de la puce sur l'ensemble pré-constitué puis le frittage de la puce sur la pâte non séchée de faible épaisseur sous faible pression (3MPa, 275 s à 280°C).

On améliore ainsi la mouillabilité par le fait d'avoir une pâte non séchée.

Les avantages de ce second exemple de procédé résident notamment dans :
- l'utilisation d'un seul type de pâte à fritter (avec pression) qui est moins cher et plus facilement processable ;
- la sérigraphie d'une épaisseur faible de pâte tout en utilisant un écran d'épaisseur standard. Cette faible épaisseur permet d'évacuer les liants sans problèmes lors du procédé d'assemblage, elle permet donc de s'affranchir de l'étape de séchage ;
- l'obtention d'une meilleure adhésion entre le joint et la puce (qui est souvent le point faible), même à bas niveau de pression (< 9MPa)

## Revendications

1. Assemblage comprenant un premier élément présentant un premier coefficient de dilatation thermique, un second élément présentant un second coefficient de dilatation thermique et au moins un joint reliant ledit premier élément et ledit second élément, **caractérisé en ce que** ledit joint est hétérogène et comporte un empilement d'au moins un premier joint élémentaire de première densité et d'un second joint élémentaire de seconde densité, lesdites première et seconde densités étant différentes.

2. Assemblage selon la revendication 1, **caractérisé en ce que** l'un des éléments comprend un composant semi-conducteur, pouvant être une diode silicium.

3. Assemblage selon l'une des revendications 1 ou 2, **caractérisé en ce que** ledit joint hétérogène est métallique.

4. Assemblage selon l'une des revendications 1 à 3, **caractérisé en ce que** le premier élément et/ou le second élément présente(nt) une surface métallique à assembler et reliée audit joint.

5. Assemblage selon l'une des revendications 1 à 4, **caractérisé en ce qu'**au moins un des deux éléments est un substrat céramique pouvant être en Al₂O₃ ou en Si₃N₄ ou en AIN et pouvant comporter au moins une couche métallique sur l'une de ses faces.

6. Assemblage selon l'une des revendications 1 à 5, **caractérisé en ce que** le premier élément et le second élément présentent une couche de finition destinée à être en contact avec un des joints élémentaires.

7. Assemblage selon la revendication 6, **caractérisé en ce que** l'épaisseur de la couche de finition est de l'ordre du nanomètre ou du micron.

8. Assemblage selon l'une des revendications 1 à 7, **caractérisé en ce qu'**au moins un des premier et/ou second éléments comporte(nt) une surface en cuivre, pouvant être une couche de finition.

9. Assemblage selon l'une des revendications 1 à 8, **caractérisé en ce que** le premier joint élémentaire et/ou le second joint élémentaire comporte(nt) des nanoparticules.

10. Assemblage selon l'une des revendications 1 à 9, **caractérisé en ce que** le premier joint élémentaire comporte des microparticules, le second joint élémentaire comportant des nanoparticules.

11. Assemblage selon l'une des revendications 1 à 10, **caractérisé en ce que** le premier joint élémentaire et/ou le second joint élémentaire est (sont) à base d'argent ou de cuivre ou d'or ou d'argent et de cuivre.

12. Assemblage selon l'une des revendications 1 à 11, **caractérisé en ce que** la première densité est de l'ordre de 90% par rapport au métal massif pouvant être de l'argent, la seconde densité étant de l'ordre de 60 % par rapport au métal massif pouvant être de l'argent.

13. Procédé de fabrication d'un assemblage comprenant un joint hétérogène en densité et deux éléments de coefficient de dilatation thermiques différents, comprenant les étapes suivantes :
- le dépôt d'une première pâte ou d'un premier film à la surface du premier élément ;
- une première opération de frittage dans des premières conditions de température et de pression de manière à réaliser un premier joint élémentaire de première densité ;
- le dépôt d'une seconde pâte ou d'un second film à la surface dudit premier joint élémentaire ;
- une seconde opération de frittage dans des secondes conditions de température et de pression de manière à définir un second joint élémentaire de seconde densité différente de ladite première densité à la surface du premier joint élémentaire pour former ledit joint hétérogène ;
- l'application du second élément.

14. Procédé de fabrication d'un assemblage selon la revendication 13, **caractérisé en ce que** la première et/ou la seconde pâte est(sont) métallique(s) ou le premier film et/ou le second film est(sont) métallique(s).

15. Procédé de fabrication d'un assemblage comprenant un joint hétérogène selon l'une des revendications 13 ou 14, **caractérisé en ce que** la seconde opération de frittage est réalisée dans des conditions de température et/ou de pression moins élevée(s) que celles de la première opération de frittage.

16. Procédé de fabrication d'un assemblage comprenant un joint hétérogène selon l'une des revendications 13 à 15, **caractérisé en ce que** la première opération de frittage est réalisée en appliquant une pièce intermédiaire sur ladite première pâte déposée ou sur ledit premier film, pouvant être une plaque de verre ou un élément en Téflon®, ou un élément en céramique, ou un élément en aluminium, ou un élément en diamant, ou un élément en saphir, ou un élément en silicium, ou un élément en carbure de silicium.

17. Procédé de fabrication d'un assemblage comprenant un joint hétérogène selon l'une des revendications 13 à 16, **caractérisé en ce que** la seconde opération de frittage est réalisée en appliquant le second élément sur la seconde pâte ou sur le second film.

18. Procédé de fabrication d'un assemblage comprenant un joint hétérogène selon l'une des revendications 13 à 17, **caractérisé en ce qu'**il comprend une étape de séchage de ladite première pâte et/ou une étape de séchage de ladite seconde pâte.

19. Procédé de fabrication d'un assemblage comprenant un joint hétérogène selon l'une des revendications 13 à 18, **caractérisé en ce que** le dépôt de la première pâte et/ou le dépôt de la seconde pâte est(sont) réalisé(s) par sérigraphie.

20. Procédé de fabrication d'un assemblage comprenant un joint hétérogène selon l'une des revendications 13 à 19, **caractérisé en ce que** le premier élément comprenant une surface en cuivre, la première pâte est à base d'argent, la seconde pâte étant également à base d'argent.

21. Procédé de fabrication d'un assemblage comprenant un joint hétérogène selon l'une des revendications 13 à 20, **caractérisé en ce que** la première et/ou la seconde pâte comprend(comprennent) des nanoparticules métalliques.

22. Procédé de fabrication d'un assemblage comprenant un joint hétérogène selon l'une des revendications 13 à 21, **caractérisé en ce que** le premier élément est un substrat, le second élément est une puce semiconductrice.

23. Procédé de fabrication d'un assemblage comprenant un joint hétérogène selon l'une des revendications 19 à 22, **caractérisé en ce que** le dépôt de la première pâte et le dépôt de la seconde pâte sont réalisés par sérigraphie avec le même type de pâte à fritter, l'épaisseur de la première pâte déposée pouvant être plus élevée que l'épaisseur de la seconde pâte déposée.
